(19) Europäisches Patentamt
European Patent Office
Office européen des brevets

(11) **EP 4 224 497 A1**

(12) **EUROPEAN PATENT APPLICATION**

(43) Date of publication:
**09.08.2023 Bulletin 2023/32**

(21) Application number: **22155655.8**

(22) Date of filing: **08.02.2022**

(51) International Patent Classification (IPC):
*H01G 11/08* $^{(2013.01)}$   *H01G 11/02* $^{(2013.01)}$
*H01G 11/52* $^{(2013.01)}$   *H01G 11/58* $^{(2013.01)}$
*H01G 11/46* $^{(2013.01)}$   *H01L 45/00* $^{(2006.01)}$
*H01G 11/04* $^{(2013.01)}$   *H01G 11/48* $^{(2013.01)}$
*H01G 11/62* $^{(2013.01)}$

(52) Cooperative Patent Classification (CPC):
**H01G 11/02; H01G 11/08; H01G 11/46;**
**H01G 11/52; H01G 11/58; H10N 97/00;**
H01G 11/04; H01G 11/48; H01G 11/62

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Studiengesellschaft Kohle gGmbH**
**45470 Mülheim (DE)**

(72) Inventors:
• **MARLOW, Frank**
  **51107 Köln (DE)**
• **MOHAMED, Elalyaa**
  **45468 Mülheim an der Ruhr (DE)**
• **JOSTEN, Sabine**
  **47228 Duisburg (DE)**

(54) **IONIC VOLTAGE EFFECT TRIODE CELL**

(57)    The present invention refers to an ionic voltage effect triode cell. In more detail, the present invention refers to the construction and characterization of an ionic soft triode cell intended to be based on interfacial ion adsorption and redox oxidizer depletion.

Figure 1

EP 4 224 497 A1

**Description**

The present invention refers to an ionic voltage effect triode cell. In more detail, the present invention refers to the construction and characterization of an ionic soft triode cell intended to be based on interfacial ion adsorption and redox oxidizer depletion.

Iontronics is a wide concept of controlling electronic devices using ions. The word became widely known in 2010 when a book with this word in its title was published. However, there have been several attempts in the direction of controlling electronics with electrolytes already in the past.

As ions move much slower than electrons the iontronic devices cannot compete with classical electronics in speed. On the other hand, iontronic devices are expected to open a new door for many applications based on their low costs, on their potential coupling to biological systems, and on carrying chemical information that allows regulating selectively different functions and processes. Despite the outstanding performance of electronic devices, they also have limitations in using them as building blocks in so-called neuromorphic devices and systems. The iontronic devices may fill gaps here. Many of them were invented in the last decades like ion-ion transistors, ion capacitors and ion memories.

Ionic amplification was first recognized in a microfluidic ionic bipolar junction transistor. With an ionic bipolar transistor, a current gain reached 10 was achieved by using and emitter gain voltage of 4V. The ionic field effect transistors represents another type of ionic transistors where ionic or molecular species in micro or nanofluidic systems are controlled by an electric field on the gate electrode of the transistor. Most of these devices can be used as amplifiers. However, the channels in most of the mentioned transistors are semiconductors or semiconducting polymers that need a sophisticated materials and construction methods. Although many ionic devices were developed, there is not much research on signal amplification in ionic systems yet. To improve the biological and chemical sensing, more ionic devices with amplification function would offer new solutions for low-cost devices.

Another important element in electronic and iontronics is a memory. There are many different types of new memory devices but the most interesting type seems to be the resistive switching memory, also called memristor. A resistive switching memory is a device with low energy consumption, mostly fast operation and simple structure. These memories are expected to open a new door for computing systems and biological applications. There are different working principles for this type of memories like electrochemical reactions, vacancy-based resistance changes/charge trapping, and phase-change materials. Most of known resistive switching memories are built with an insulator between two metals (MIM). They show interesting non-linear behavior in circuits, but also some problems like the stability and device integration.

In view of said prior art, the present inventors developed a new, purely ionic device with amplification behavior and a memory function that is called, by the inventors, ionic voltage effect soft triode (IVEST). This device is exemplified by a simple electrochemical microcell which comprises, in its most simple form, a top electrode and two bottom electrodes. The basic idea of this device is to control the concentration and diffusion of ions by the voltage applied on the top electrode. This electrode is exemplarily covered by porous titania, a material which can adsorb ions dependent on its potential. The advantages of this device are the ability to be used as an amplifier or a memory, the ease to be manufactured, the low power consumption and the avoidance of any ultra-pure semiconducting material. The need of eco-friendly devices is increasing and using abundant materials and less sophisticated manufacturing methods is a challenge nowadays.

Therefore, there is a need for an improved device for the above reasons.

Accordingly, the present invention is directed to an ionic voltage effect triode cell comprising comprising a compartment with an internal cavity comprising in the cavity:

   a. at least one top electrode T, to which an electric potential is applicable and which is preferably being coated with a porous layer,
   b. at least two base electrodes B1 and B2 spaced apart to each other and being preferably coated with carbon, a noble metal selected from Ag, Au, Pt, Pd and alloys thereof, or any combination thereof,
   c. an redox-electrolyte solution filling the cavity of the cell,

wherein the electrodes T, B1 and B2 are consisting of a conductive metal, preferably selected from a metal such as stainless steel, carbon, a conducting polymer, a conducting oxide or any combination thereof, and wherein the electrolyte solution is adjusted in its concentration to be capable of providing a current flow between the at least two base electrodes B1 and B2.

The at least one top electrode T is generally used in the form of a sheet or in the form of a net made of metal wires, generally having a diameter of $100\mu m$ to $200\ \mu m$, in order to increase the surface of the electrode T. The porous layer, preferably in the form of a semiconductor layer, on the top electrode T generally serves for attraction and "storing" the ions of the electrolyte when a potential is applied to the at least one top electrode T. The porous layer usually has a thickness between $0.5\ \mu m$ and $10\ \mu m$, more preferably between $0.7\ \mu m$ and $10\ \mu m$. By this attraction, the electrolyte is depleted in ions and the current flow between the at least two base electrodes B1 and B2, which are usually used each in the form of a wire generally having a diameter of 100$\mu$m to 200 $\mu$m, is reduced. Usually, the at least one top electrode T is located at a side wall of the cavity and has an areal size which is larger than the distance between the at least two base electrodes B1 and B2. In one embodiment, the areal size of the top electrode T is corresponding to the size of the side wall, for example, wherein the cavity may have a cuboid form or cylindrical form and is present, in particular, as a flat cuboid cavity or a flat cylindrical cavity. Generally, the cavity including the such formed cavity may have a volume of a few hundred $\mu$m$^3$ up to 1 cm$^3$.

The ionic voltage effect triode cell is preferably comprising additionally a permeable separator sheet disposed between the top electrode T and the two base electrodes B1 and B2. The at least one top electrode is spaced apart from the at least two base electrodes B1 and B2 and separated from a direct contact with the at least two electrodes by said separator sheet. Said permeable separator sheet is advantageously a porous membrane with pores having a pore size of less 100 $\mu$m, preferably less 10 $\mu$m and more preferably less than 2 $\mu$m, preferably measured by optical microscopy or permeation. Further preferably, said permeable separator sheet is a porous membrane sheet with a sheet thickness of less than 200 $\mu$m, preferably less than 50$\mu$m and more than 10$\mu$m, preferably measured by optical microscopy, which method being preferably used for all measurements of lengths and thicknesses, or by SEM measurements, and advantageously a porous membrane sheet made of polypropylene, polyethylene, copolymers thereof, or polymers containing them.

In the inventive ionic voltage effect triode cell, the at least one top electrode T is in particular coated with a porous semiconductor layer selected from TiO$_2$ or ZnO.

In another embodiment, the ionic voltage effect triode cell according to the invention anyone of the preceding claims wherein one or two additional base electrodes B0 and/or B3, preferably being coated with carbon, a noble metal selected from Ag, Au, Pt, Pd and alloys thereof, or any combination thereof, is/are disposed between the at least two base electrodes B1 and B2 or aside to them which one or two further base electrodes B0 and/or B are configured as counter electrode(s) for the T-electrode(s). Said embodiment allows the easy application of voltages to the T-electrode(s).

The ionic voltage effect triode cell according to the invention comprises a redox-electrolyte solution which is particularly selected from solution of a I$^-$/I$_3^-$ redox pair in a polar organic solvent, exemplarily selected from 3-methoxypropionitrile or ethylene glycol, or a solution of a Co$^{2+}$/Co$^{3+}$ redox pair in a polar organic solvent or inorganic solvent such as water. The concentration of the respective redox pair (with an ratio of about 10:1) is usually in the range of 2 mmol/l to 0.05 mmol/l, preferably in the range of 0.8 mmol/l to 0.1 mmol/l for the higher concentrated pair element.

In a further embodiment, the ionic voltage effect triode cell according to the invention is a sheet-like cell comprising the electrodes and the optional permeable separator sheet as sheets tightly disposed on each other, preferably prepared by 3D-printing. In said embodiment, the optional permeable separator sheet also serves as insulator sheet between the at least one top electrode T, to which an electric potential is applicable and which is preferably being coated with a porous semiconductor layer, and the at least two base electrodes B1 and B2.

In said latter embodiment, the elements of the cell constituting the cell walls, the at least one top electrode T, the optional permeable separator sheet and the at least two base electrodes B1 and B2 are printed stepwise onto each other by means of a 3D printer and the redox-electrolyte solution filling the cavity of the cell is injected into the formed cavity of the compartment.

The inventive ionic voltage effect triode cell can preferably be used for amplifying, changing and/or storing electrical signals, potentials, currents or charges in a digital or analogous manner.

The invention is further illustrated by the attached Figures and following Experimental Part. In the Figures, the Figures illustrate the following:

Figure 1: (A) Device construction, (B) device symbol, and (C) two-gate configuration. T, B1, and B2 are the names of the three electrodes as explained in the text. The idea of the device is the control of the current $J_{BB}$ (red arrow) by the potential $V_T$. The top electrode (T) is made of porous TiO$_2$, which can adsorb ions dependent on its potential as it is used in so-called dye-sensitized solar cells. For device characterization, a BB symmetric configuration with R1 = R2 = 2 kOhm was selected.

Figure 2: The Sym-BB-$\Omega$ measurement configuration. The resistance between the bottom electrode is measured dependent on top voltage. The B-electrodes are symmetric in respect to the top voltage.

Figure 3: Basic characterization of a non-optimized IVEST

- (A) Sym-BB input characteristics. At the output constant $V_{BB}$ values were applied from 0 V to 0.4 V. The LIC range (see below) is indicated in the figure.
- (B) Sym-BB output characteristics. $V_{BB}$ was scanned by a $JV$ measurement device whereas at the input fixed values of $V_{top}$ were applied from -0.8 V to 0.8 V.

- (C) Transfer curve.
- (D) Differential transconductance calculated from eqn 1 at small values of $V_{BB}$. Five similar samples have shown nearly the same characteristics.

Figure 4:

- A) The BB resistance at permanent control voltage measured in a pulsed manner with about 10 s waiting time after every $V_{top}$ change. When a positive voltage is applied on the top electrode, $R_{BB}$ increases and when a negative $V_{top}$ is applied it decreases. The dashed lines indicate the range of low top-electrode current.
- (B) Switching measurements with a voltage protocol shown in the lower part of the diagram. A positive voltage was applied on the top electrode for 1 min. Then, the $R_{BB}$ at open top circuit conditions was measured for 2 min. This process was repeated with negative $V_{top}$. A difference of resistances of $\Delta R_{BB}$ = 0.56 k$\Omega$ was found. A high and low resistance state (HRS and LRS, respectively) is clearly visible.

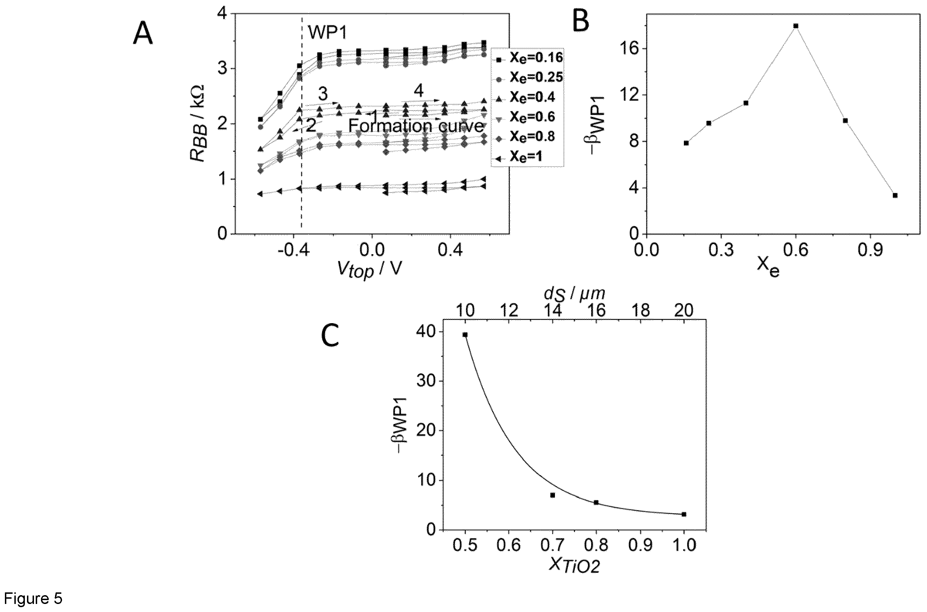

Figure 5: Tuning of device parameters.

- (A) Effect of electrolyte dilution on $R_{BB}$ measured by a pulsed DC resistance measurement.
- (B) Calculated amplification at WP1 (Working point 1, Vtop = -0.37V) at different electrolyte concentrations.
- (C) Calculated amplification at different TiO$_2$ thicknesses, determined analogously as in (A) and (B). The thickness scale was constructed from two SEM investigations of the electrodes.

Figure 6:

- (A) Effect of TiO$_2$ thickness on $\Delta_2 R_{BB}$.
- (B) Effect of electrolyte concentration on $\Delta_2 R_{BB}$.
- (C) Effect of membrane pore size on $\Delta_2 R_{BB}$.
- (D) Effect of membrane pore size on the stability. There is a big increase in $\tau_2$ when a membrane with small pore size is used for the separation the device parts. The solid lines are guides for the eye.

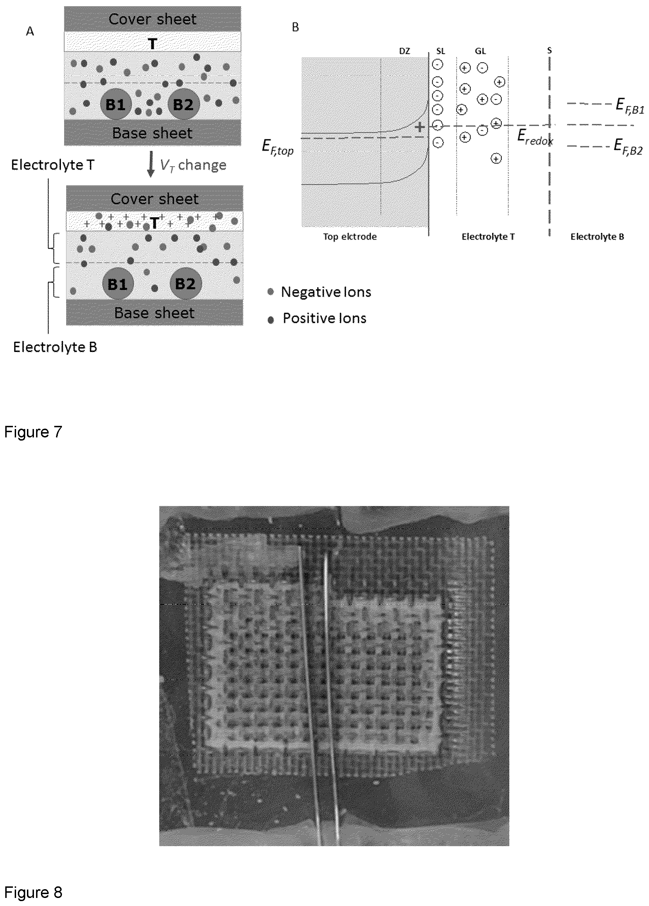

Figure 7: (A) Schematic description of the mechanism of the device. (B) The IVEST energy levels and relevant charge layers. The image shows the electronic depletion zone (DZ), the Stern layer (SL), the Gouy layer (GL), and the separator (S). The left half of Fig. 7B is the classical description of a semiconductor electrolyte interface. The right half is the proposed coupling to the bottom part of the electrolyte. The Fermi energy offsets are generated by external voltages.

Figure 8 shows the coloration of the B-electrodes of the inventive device.

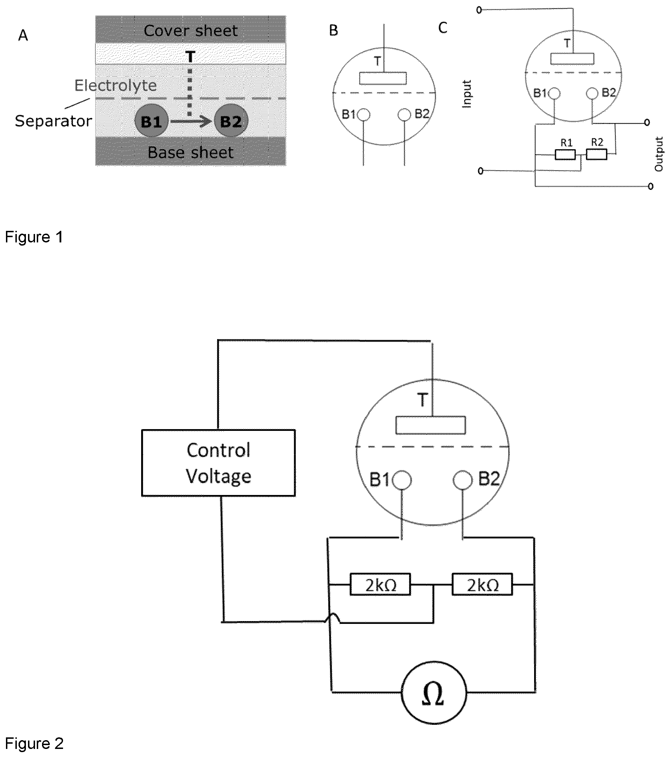

As shown in Figure 1, the general layout of the device is shown. Parts of the device as well as their fabrication were adapted from the elaborated and optimized construction of dye-sensitized solar cells and were also inspired on other attempts with TiO$_2$ nanoparticles in optical or electronic applications. In solar cells, all parts are adjusted to each other. This explains the special selection of the electrolyte as well as of sealing materials. Essentially, the device consists of three electrodes, all based on stainless steel.

For the top electrode, a metal mesh of $9\times5$ mm$^2$ was cleaned and dip-coated with a TiO$_2$ precursor solution. After solidifying at 120°C, a suspension of TiO$_2$ nanoparticles was dip-coated and sintered at 450 °C. The detailed processes have been adapted from solar cell fabrication and modified for the metal meshes. The resulting thickness of the nanoporous TiO$_2$ is about 20 $\mu$m for the non-diluted coating suspension (see below) and is reduced with suspension dilution. For the bottom electrodes, after wet-chemical cleaning, 1 nm of Pt was deposited on both sides of the wires by sputtering (Q150T S, Quorum GmbH).

For the device fabrication, a polypropylene film with thickness of 30 $\mu$m is used as base for the device. The two bottom electrodes were put on it. A polypropylene mesh (Franz Eckert GmbH) with a typical thickness of 200 $\mu$m or a membrane (described below) was put on the top of the bottom electrodes as a spacer and separator. The top electrode was placed on the top of the separator sheet as shown in Fig. 1A. In addition, a polypropylene top layer was used for encapsulation and the system was glued together using a hot press (Lotus Transpresse LTS 12S) at 110°C. The electrolyte was injected inside the device using a syringe. Finally the device opening was sealed using a metal hot spot (Wetekom soldering station) at 150°C.

Referring to Figure 2, different measurement configurations were used to characterize the device. The most important measurement to see both the memory function and the amplification behavior turned out to be the one shown in Fig. 2. Here the resistance between the two bottom electrodes $R_{BB}$ is measured (IDM93N, RS PRO GmbH). Typical test currents were 40 μA. Continuous as well as pulsed (typical time 1 s) measurements have been carried out. For additional characterization, the current on top electrode ($J_{top}$) was measured by applying a fixed voltage between the two bottom electrodes ($V_{BB}$) and using a JV analyzer. To characterize the output current ($J_{BB}$), the top electrode was connected to power supply and the bottom electrodes to the JV analyser. The thickness of the TiO$_2$ layer of the electrodes was investigated with a SEM (TM3030, Hitachi).

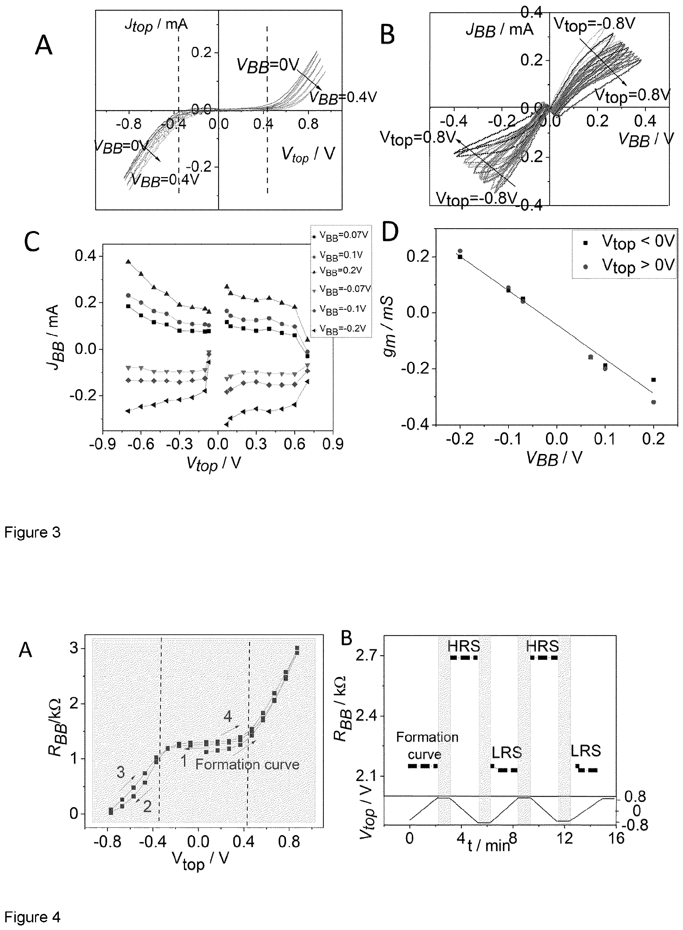

As in Figure 3, the device can be regarded as a 2-gate with input and output. Therefore, the device was characterized with different methods adapted from classical transistor measurements. The results in Fig. 3A reveal a strongly nonlinear dependence of the input current from the input voltage $V_{top}$ and a week dependence of the input current from $V_{BB}$. This difference of sensitivity supports our selection of the input and output gate. The weak dependence of the input current on output voltage means a low back-action. Fig. 3A shows the result at positive values of $V_{BB}$ only. The results for negative values are nearly identical with only small indications for asymmetries. There were some small unavoidable asymmetries in the construction in the two bottom electrodes which may have led to small asymmetry in the results. Additionally, it is important to note that the input current is very low at $V_{top}$= -0.37 V to 0.5 V. The inventors call this range the low-input current (LIC) range.

The output current $J_{BB}$ was measured. Generally, the output curves are nearly linear and resemble to a resistor. However, this resistor of the output gate depends on the input. In Fig. 3B it is visible that the resistance increased by increasing $V_{top}$. The voltage applied on the top electrode was kept lower than 1 V to avoid chemical reactions that may happen inside the system.

The magnitude of the output current as well as of the output resistance represent major differences of the IVEST in comparison to the other proposed ionic transistors. Varying the input voltage from 0 to -0.6 V causes a change in the output current by 0.1 mA at $V_{BB}$ = 0.2 V. This change in the output current is much higher than in some known ionic transistors where the same change of input voltage causes a change in the output current of less than 0.002 mA at the output voltage of $V_D$ = 0.2 V.

As shown in Figure 3, the output shows a visible hysteresis. This hysteresis can be attributed to several reasons, but the most important ones seem to be the delay in ion motion and ion redistribution. From the first look the hysteresis seems to be a drawback of the device intending amplification and switching applications, but at further investigations it turns to be an interesting option of the device that will be discussed below. There, the inventors discuss useful memory effects which have achieved from systematically increasing the hysteresis.

A transfer curve usually describes the interconnections of input and output. In Fig. 3C, the output current was plotted at different input voltages $V_{top}$ (Fig. 3C). The output current started change significantly at higher absolute values of $V_{top}$. To evaluate the performance of the device in this range, the differential transconductance $g_m$ was calculated at different working points (i.e. at different $V_{top}$ and $V_{BB}$ values). The differential transconductance $g_m$ is defined by the following equation which deviates slightly from the frequently used non-differential value $g'_m = I_{out}/V_{in}$:

$$g_m = \frac{\partial J_{BB}}{\partial V_{top}} \tag{1}$$

This enables the direct determination of $g_m$ from transfer curves. The resulting $g_m$ is shown in Fig. 3D. The values are significantly higher than the $g_m$ of known electric double layer transistors with values of 0.04 and 0.17, but lower than values for commercial electronic devices. The inventors will discuss this issue below again. Here the inventors also remark an interesting $V_{BB}$ dependence of the transconductance:

$$g_m = \gamma_{BB} * V_{BB}. \tag{2}$$

This allows the introduction of the "specific differential transconductance" $\gamma_{BB}$. It reflects the nearly ohmic output and represents a big difference to the conventional transistor and the MOSFET.

In the LIC range the input curve has revealed a high resistance in comparison to the output resistance $R_{BB}$. When a slight change in the input current $J_{top}$ happened, a significant change in the output current $J_{BB}$ took place. This interconnection will be interpreted in the following section in terms of amplification.

As illustrated in Figure 4, because the device has nearly ohmic output characteristics, the characterization measurements can be simplified by using a standard ohm-meter instead of the JV analyzer. The use of a stand-alone ohm-meter not only shortens the measurements, but it also avoids the problem of possible ground interconnection effects between the different parts of the setup. When a positive voltage was applied on the top electrode, the resistance between the two bottom electrodes increased and when a negative voltage was applied on the top electrode, the resistance between the two bottom electrodes decreased as shown in Fig. 4A. As Fig. 3A, Fig. 4A can be split into two parts, the middle part where $V_{top}$= -0.37 V to 0.5 V and the corresponding outer part. In the middle part the change in resistance is low. To introduce the relation between the output and the input, the ratio between $J_{top}$ and $J_{BB}$ was investigated based on the amplification definition described in eqn 3. The inventors call it current amplification or $J$-amplification. Eqn 4 represents the relation of the amplification to the system parameters at a certain working point (WP).

$$\beta_{d,WP} = \frac{\partial J_{out}}{\partial J_{in}} \qquad (3)$$

$$\beta_{d,WP} = \gamma_{BB}(V_{top}) \frac{V_{BB}}{G_{d,top}(V_{top})} \qquad (4)$$

Interestingly, $\gamma_{BB}$ can also be determined from the output resistance measurement namely as the differential quotient between the output conductivity and the top voltage. Therefore, one has two possibilities for the $\gamma_{BB}$ determination, either from the transfer curve or from the transfer conductance which is measured utilizing a different setup (Fig. 2C). The best $J$-amplification after optimization was $\beta$ = -52 at the working point WP1 = (-0.37 V, 0.25 V).

Here, the first value of this pair WP = ($V_{top}$, $V_{BB}$) describes the input voltage and the second one the output voltage. The outer part of the graph (i.e. the non-LIC range) is defined by high $|V_{top}|$ values when either 0.5 V < $V_{top}$ or $V_{top}$ < -0.37 V. In these two ranges, the output resistance showed a rapid change when changing $V_{top}$. In addition, a hysteresis becomes visible in most curves when this range of voltage is touched. Likely, these effects are caused by a relatively low input current. A high input current may cause ion redistribution and non-equilibrium states. These states can be responsible for the hysteresis which could possibly lead to a useful memory effect.

To obtain a deeper insight in the hysteresis and memory behaviour, a special experiment was developed using a control voltage protocol as shown in Fig. 4B. In this experiment, no voltage was applied on the top electrode ($V_{top}$= open) during a certain "readout time". The resistance was measured in a pulsed manner, i.e. with minimal currents between the B electrodes. The readings were taken each 10 s for 2 min (read-out time). Then, a positive voltage was applied on the top electrode ($V_{top}$= 0.8 V) for 1 min (writing period). After this minute, the voltage applied on the top electrode was switched off ($V_{top}$= open) and, again, the $R_{BB}$ readings were taken each 10 s for 2 min. Then, in another writing period, a negative voltage was applied on the top electrode for 1 min ($V_{top}$= -0.8 V). After that, the resistance readings were taken again for 2 min.

Obviously, the IVEST can remember the "writing" during the readout periods. The device is either in a high or in a low resistance state (HRS or LHS, respectively). Within these states, there are small changes as well, but the memory character is not destroyed. In detail, one finds that the resistance readings showed a slight increase in the LRS with time and a slight decrease in the HRS.

As visible, the two states shown in Fig. 3B are fairly stable and, therefore, represent a useful memory behavior of the device. The difference between the two states reached values up to $\Delta R_{BB}$= 0.56 k$\Omega$ in this experiment. Another measure of the memory contrast is the ratio between the resistance of the HRS and the LRS which can be expressed by

$$\alpha = \frac{H}{L} = \frac{R_{BB}^H}{R_{BB}^L} \qquad (5)$$

A value of about 1.3 was found for some devices as described below.

In Fig. 4A, a hysteresis has appeared when top voltage exceeded the LIC region. This hysteresis indicates a possible memory effect. Enlarging this hysteresis was, therefore, the way of optimizing this potential memory. Finally two properties, the resistance contrast $\Delta_2 R_{BB}$ and the stability time $\tau_2$, were used to characterize the efficiency of the memory. The stability time is the time that the two metastable states require to reach an equilibrium state. The difference of resistance between the HRS and the LRS after two minutes $\Delta_2 R_{BB}$ was used to characterize the memory contrast.

Another factor that affects the amplification is the thickness of the TiO$_2$ layer on the top electrode tuned by $X_{TiO2}$. As shown in Fig. 4C the tuning curve exhibits a maximum at the thinnest TiO$_2$ layers. The negative current amplification reaches 52 at $X_{TiO2}$ = 0.5. It seems that high amounts of the semiconductor at the top electrode are not beneficial for the amplification. One may correlate this fact with the amount of dead material. When the thickness of TiO$_2$ layer on the top electrode increases, more and more parts of the material are not in electrical contact with the metal mesh ("dead material"). The dead material can, however adsorb electrolyte ions. Since, they have no electrical contact with the electrode, they have no beneficial effect on the amplification but they are lost for the other processes. Thinner TiO$_2$ layers are technically not possible at the moment. However, one can expect a further increase of the amplification at thinner layers.

Referring to Figure 5, in order to investigate the nature of the amplification process and to explore the possibilities of an application, the variation of the amplification values by device variation was investigated. Two factors that were expected to have big effect on the amplification were tested. In addition, a working point WP1 at $V_{top}$ = -0.37 V and $V_{BB}$= 0.25 V was selected for the following discussions. At this point one has the maximum amplification effects among our measured values.

The first factor important for the amplification is the electrolyte concentration $X_e$ (Fig. 5A&B). A series of diluted electrolytes were tested as shown in Fig. 5A. The results showed an increase in the resistance as the electrolyte was diluted. This can be attributed to fewer amounts of ions in the electrolyte. The amplification increased by increasing the concentration of the electrolyte until it reached the highest value at $X_e$ = 0.6 and then it decreased as shown in Fig. 5B.

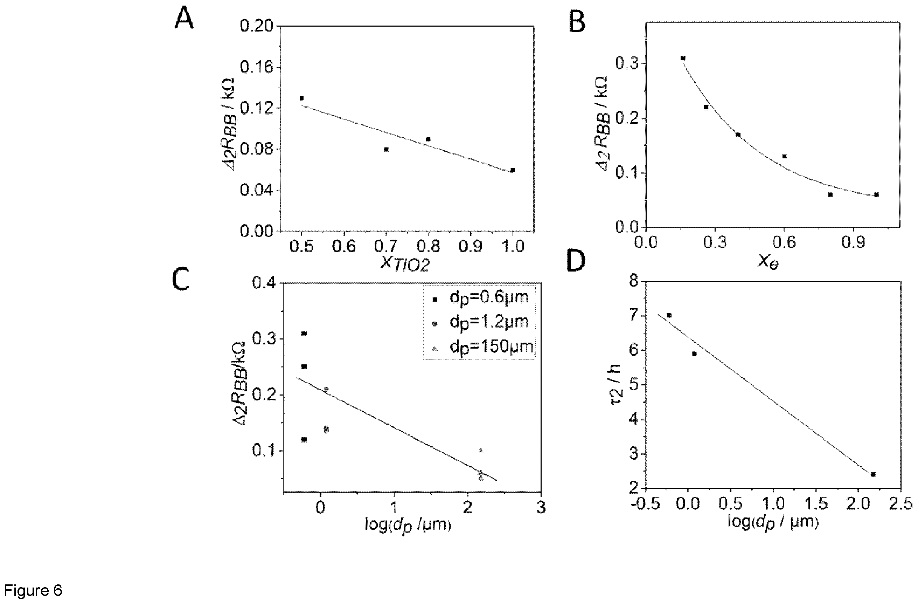

Referring to Figure 6: As the adsorption of the ions on the TiO$_2$ layer likely plays a role in the mechanism of the device (see section 4.2), the behavior of the IVEST was tested at different electrode thickness realized by different concentrations of TiO$_2$ in the dip-coating suspension. In Fig. 6A one can see that $\Delta_2 R_{BB}$ moderately increased by decreasing the concentration of TiO$_2$. This increase in $\Delta_2 R_{BB}$ could likely be attributed to the decreasing of dead material or the rim on the top electrode. The second factor that affects $\Delta_2 R_{BB}$ is the electrolyte. The difference between the two switching states $\Delta_2 R_{BB}$ increased when the electrolyte was diluted (Fig. 6B). The pore size of the membrane separating the device parts is also expected to have an influence on the memory behavior. This was indeed found. As the pore size decreased, $\Delta_2 R_{BB}$ showed an increase. The factor that affects the stability time the most was also found to be the pore size of the membrane. By decreasing the pore size, $\tau_2$ increased. There was a big difference in $\tau_2$ when using a membrane with 150 $\mu$m pore size and membranes with pore sizes < 1.5 $\mu$m. Based on the previous results, an optimized cell for memory effects was built with $X_e$ = 0.16, $X_{TiO2}$ = 0.5, and a spacer of 1.2 $\mu$m pore size. In case of the optimized cell, a value of $\Delta_2 R_{BB}$ = 0.56 k$\Omega$ and $\tau_2$ = 5.8 h were found, leading to a contrast factor of $\alpha$ = 1.28. This cell was also shown in Fig. 4B.

In Fig. 7(A), a schematic description of the mechanism of the device is given. Fig. 7(B) illustrates the IVEST energy levels and relevant charge layers. The image shows the electronic depletion zone (DZ), the Stern layer (SL), the Gouy layer (GL), and the separator (S). The left half of Fig.7B is the classical description of a semiconductor electrolyte interface. The right half is the proposed coupling to the bottom part of the electrolyte. The Fermi energy offsets are generated by external voltages.

Device Fabrication

Generally, for the top electrode, a metal mesh made of stainless steel (316Ti, Haver & Boecker) with a mesh width of 0.315 mm and a wire diameter d = 0.2 mm may be used. The bottom electrodes were usually wires of same steel material from Edelstahlzieherei Hillesheim GmbH with diameter 0.15 mm. The chemicals used for the coating solutions and for the electrolytes were the same as in the former DSSC publication (IEEE JOURNAL OF PHOTOVOLTAICS, VOL. 10, NO. 2, MARCH 2020) of the inventors and were used as received. Fig. 8 shows the IVEST after a large number of electrical measurements. Its appearance has not changed by the measurements.

While trans-conductance phenomena only need instantaneous interactions and nonlinearities for explanation, memory effects are based on multi-stability or non-equilibrium states. For the inventive device, non-equilibrium phenomena seem most important to the inventors. A distinction should be made between the "main memory effect", i.e. the memory effect which is intended to be used in a device, and other memory effects which only disturb the inventor's measurements.

The basic action of the device can be regarded as a potentiometer with external control voltage. This control voltage has a very nonlinear effect as visible in Fig. 4. Partially these effects are instantaneous, partially they can be modified by waiting time. Therefore, the inventors think that two mechanisms contribute to the effect. The first is the voltage-controlled adsorption of ions in the TiO$_2$ electrode and the second is the ion transport through the membrane. Both mechanisms can change the concentration of ions. The instantaneous effect can be good to construct an amplifier. Using a relatively long writing period, the transport phenomena become dominating.

The observed nonlinearity of the control current dependent on the control voltage might be regarded as a useful feature. It creates an in-build threshold switch or, more generally, an activation function in neural networks. The basic potentiometer characteristics in the output is well suited for perceptrons or neuromorphic networks for realizing signal weighting.

The main memory effect found in the IVESTs can likely be explained by the different concentration of ions between the two parts of the device. The T-part of IVEST is the top electrode and a part of the electrolyte, while the second part of the IVEST consists of the two bottom electrodes and the electrolyte surrounding them ("B-part"). When a voltage is applied, gradients of the electrolyte ions are formed in the device creating non-equilibrium states between the two parts of the device. In the readout phase (i.e. without control voltage), the ions need time to redistribute again and to reach an equilibrium state. This time (stability time) is usable for the memory.

As shown above, a new purely ionic soft triode was constructed. It can be used as a memory or an amplifier. Two physico-chemical principles are likely realized in the device, ion adsorption in a porous electrode and redox oxidizer depletion. Both principles allow a wide range of chemical tuning. A non-equilibrium of ions occurs between the two parts of the device can be used to control the current in the device.

Different simple tuning factors were studied. The amplification of the device was optimized and reached a value of $\beta$ = -52. The memory effect was optimized and reached $\Delta_2 R_{BB}$ = 0.56 k$\Omega$ and $\tau_2$ = 5.8 h by using a membrane with a pore size of 1.2 $\mu$m, an diluted electrolyte (16% of our standard) and a thinner titania layer (of about 10 $\mu$m). The high stability time of the device allows it to be used as memory element in different applications such as sensor systems, health care applications and neuromorphic memories. This device could be a building block for neuromorphic information processing systems and could, therefore, be a step towards a new computational technology.

The device has several advantages in comparison with known devices such as the possibility of a green fabrication involving no high-temperature step, the possibility of incorporation into printable electronics, and the low power consumption of such devices. It should be underlined that there is no need to use a semi-conductor material to create a channel between the bottom electrodes. This would always increase the production costs. The liquid electrolytes seem to be a drawback, but existing widely-used devices as batteries and electrolytic capacitors show that one can well manage the technical requirements. In addition, solid or gel electrolytes can be used for such devices as well.

From the device point of view, it is interesting that the IVESTs have a controllable linear ohmic output. This is a difference to the known devices, which have strongly non-linear output characteristics. However, this fact enables and enforces modified circuit layouts.

As discussed, the soft triode was built in a simple manner with no need of sophisticated or expensive materials. It is not utilizing the control of a semiconducting channel, but an electrolyte. In different electrical circuit configurations, it can show amplification or memory effects. The device had an electrical current amplification reaching 52 and memory effects in the electrical resistance lasting for up to 6 h. These values were achieved by tuning an electrode interface, the electrolyte and diffusion properties. They are promising for neuromorphic applications.

## Claims

1. An ionic voltage effect triode cell comprising a compartment with an internal cavity comprising in the cavity:

   a. at least one top electrode T, to which an electric potential is applicable and which is preferably being coated with a porous layer,
   b. at least two base electrodes B1 and B2 spaced apart to each other and being preferably coated with carbon, a noble metal selected from Ag, Au, Pt, Pd and alloys thereof, or any combination thereof,
   c. an redox-electrolyte solution filling the cavity of the cell,

   wherein the electrodes T, B1 and B2 are consisting of a conductive metal, preferably selected from a metal such as stainless steel, carbon, a conducting polymer, a conducting oxide or any combination thereof, and wherein the electrolyte solution is adjusted in its concentration to be capable of providing a current flow between the at least two base electrodes B1 and B2.

2. The ionic voltage effect triode cell according to claim 1, additionally comprising a permeable separator sheet disposed between the top electrode T and the two base electrodes B1 and B2.

3. The ionic voltage effect triode cell according to claim 2 wherein the permeable separator sheet is a porous membrane with pores having a pore size of less 100 $\mu$m, preferably less 10 $\mu$m and more preferably less than 2 $\mu$m.

4. The ionic voltage effect triode cell according to claim 2 or 3 wherein the permeable separator sheet is a porous membrane sheet with a sheet thickness of less than 200 $\mu$m, preferably less than 50$\mu$m and more than 10$\mu$m.

5. The ionic voltage effect triode cell according to claim 2, 3 or 4 wherein the permeable separator sheet is a porous membrane sheet made of polypropylene, polyethylene, copolymers thereof, or polymers containing them.

6. The ionic voltage effect triode cell according to anyone of the preceding claims wherein the at least one top electrode T is coated with a porous semiconductor layer preferably selected from TiO$_2$ or ZnO.

7. The ionic voltage effect triode cell according to anyone of the preceding claims wherein one or two further base electrodes B0 and/or B3, preferably being coated with carbon, a noble metal selected from Ag, Au, Pt, Pd and alloys thereof, or any combination thereof, is/are disposed between the at least two base electrodes B1 and B2 or aside to them which one or two further base electrodes B0 and/or B are configured as counter electrode(s) for the T-electrode(s).

8. The ionic voltage effect triode cell according to anyone of the preceding claims wherein the redox-electrolyte solution is selected from solution of a $I^-/I3^-$ redox pair in a polar organic solvent or a solution of a $Co^{2+}/Co^{3+}$ redox pair in a polar organic solvent or inorganic solvent.

9. The ionic voltage effect triode cell according to anyone of the preceding claims wherein the ionic voltage effect triode cell is a sheet-like cell comprising the electrodes and the optional permeable separator sheet as sheets tightly disposed on each other, preferably prepared by 3D-printing.

10. Process for preparing the ionic voltage effect triode cell according to claim 9 wherein the elements are printed stepwise onto each other by means of a 3D printer and the redox-electrolyte solution filling the cavity of the cell is injected into the formed compartment.

11. Use of the ionic voltage effect triode cell according to anyone of claims 1 to 9 for amplifying, changing and/or storing electrical signals, potentials, currents or charges in a digital or analogous manner.

Figure 1

Figure 2

Figure 3

Figure 4

Figure 5

Figure 6

Figure 7

Figure 8

Europäisches
Patentamt

European
Patent Office

Office européen
des brevets

**EUROPEAN SEARCH REPORT**

Application Number

EP 22 15 5655

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SAYAGO J. ET AL: "TransCap: a monolithically integrated supercapacitor and electrolyte-gated transistor", JOURNAL OF MATERIALS CHEMISTRY C, vol. 2, no. 48, 20 October 2014 (2014-10-20), pages 10273-10276, XP055952343, GB ISSN: 2050-7526, DOI: 10.1039/C4TC02119C Retrieved from the Internet: URL:https://pubs.rsc.org/en/content/articl epdf/2014/tc/c4tc02119c> [retrieved on 2022-08-28] | 1,2,7,9, 11 | INV. H01G11/08 H01G11/02 H01G11/52 H01G11/58 H01G11/46 H01L45/00  ADD. H01G11/04 H01G11/48 H01G11/62 |
| A | * page 10273 - page 10274; figures 1,2 * | 3-6,8,10 | |
| X | & Sayago J ET AL: "Electronic Supplementary Information TransCap: a monolithically integrated supercapacitor and electrolyte-gated transistor", , 20 October 2014 (2014-10-20), XP055952350, Retrieved from the Internet: URL:https://www.rsc.org/suppdata/tc/c4/c4t c02119c/c4tc02119c1.pdf [retrieved on 2022-08-17] | 1,2,7,9, 11 | |
| A | * the whole document * | 3-6,8,10 | TECHNICAL FIELDS SEARCHED (IPC)  H01G H01C H02N H01L |
| A | JP 2002 343455 A (SHARP KK) 29 November 2002 (2002-11-29) * paragraph [0057] - paragraph [0065]; figure 1; example 1 * | 1-11 | |
| A | DE 199 51 616 A1 (FRAUNHOFER GES FORSCHUNG [DE]; UNIV LUDWIGS ALBERT [DE]) 10 May 2001 (2001-05-10) * paragraph [0015] - paragraph [0026]; figure 2 * | 1-11 | |

-/--

The present search report has been drawn up for all claims

| Place of search | Date of completion of the search | Examiner |
|---|---|---|
| Munich | 18 August 2022 | Frias Rebelo, Artur |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 22 15 5655

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2018/185257 A1 (THE PROVOST FELLOWS SCHOLARS AND OTHER MEMBERS OF BOARD OF TRINITY COL) 11 October 2018 (2018-10-11) * page 6, line 10 - page 10, line 12; figures 1a-d * | 1-11 | |
| A | STELMACH EMILIA ET AL: "Electrolyte gated transistors modified by polypyrrole nanoparticles", ELECTROCHIMICA ACTA, vol. 309, 7 April 2019 (2019-04-07), pages 65-73, XP085676391, ISSN: 0013-4686, DOI: 10.1016/J.ELECTACTA.2019.04.034 * page 65 - page 67; figures 1,7 * | 1-11 | |
| A | ZHANG EN ET AL: "Nanoporous carbon architectures for iontronics: Ion-based computing, logic circuits and biointerfacing", CHEMICAL ENGENEERING JOURNAL, ELSEVIER, AMSTERDAM, NL, vol. 420, 21 May 2021 (2021-05-21), XP086620222, ISSN: 1385-8947, DOI: 10.1016/J.CEJ.2021.130431 [retrieved on 2021-05-21] * page 1 - page 4; figures 1a-d,2A-D * | 1-11 | TECHNICAL FIELDS SEARCHED (IPC) |

The present search report has been drawn up for all claims

| Place of search | Date of completion of the search | Examiner |
|---|---|---|
| Munich | 18 August 2022 | Frias Rebelo, Artur |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 22 15 5655**

This annex lists the patent family members relating to the patent documents cited in the above-mentioned European search report.
The members are as contained in the European Patent Office EDP file on
The European Patent Office is in no way liable for these particulars which are merely given for the purpose of information.

**18-08-2022**

| Patent document cited in search report | | Publication date | Patent family member(s) | | Publication date |
|---|---|---|---|---|---|
| JP 2002343455 | A | 29-11-2002 | JP 4574897 B2 | | 04-11-2010 |
| | | | JP 2002343455 A | | 29-11-2002 |
| DE 19951616 | A1 | 10-05-2001 | NONE | | |
| WO 2018185257 | A1 | 11-10-2018 | NONE | | |

For more details about this annex : see Official Journal of the European Patent Office, No. 12/82

# EP 4 224 497 A1

**Non-patent literature cited in the description**

- *IEEE JOURNAL OF PHOTOVOLTAICS,* March 2020, vol. 10 (2